# EUROPEAN PATENT SPECIFICATION

(11) **EP 1 301 758 B1**
(45) Date of publication and mention of the grant of the patent: **12.01.2005**
(21) Application number: 01962851.0
(22) Date of filing: 11.07.2001
(51) Int. Cl.: G01D 5/39, G01D 4/00

(54) **A UTILITY METER**
VERBRAUCHSZÄHLER
APPAREIL DE MESURE D'ENERGIE

(30) Priority: 14.07.2000 GB 0017236
(43) Date of publication of application: 16.04.2003
(73) Proprietor: Landis+Gyr Limited, Telford Shropshire TF1 7YG (GB)
(72) Inventor: PAXTON-WHITE, Michael, Halifax, Yorkshire HX6 4DT (GB)
(74) Representative: Humphrey-Evans, Edward John
(86) International application number: PCT/EP2001/008013
(87) International publication number: WO 2002/006773

(56) References cited:
- EP-A- 0 242 090
- WO-A-85/05530
- GB-A- 2 228 641

## Description

### Field of the invention

The present invention patent relates to a utility meter and, in particular, relates to metering apparatus such as gas or electricity meters incorporating a bi-directional communicating circuit.

### Background to the Invention.

Electronic utility meters are becoming more widespread in use; utility companies are now specifying that new meters should be of this type whereby meter reading may be performed with high accuracy. This is because a transfer of meter reading may be performed by electro-optical means. That is to say a meter reader would visit the premises of a utility consumer, place his meter reading device against a specific reader window of the meter to enable a meter reading to be conducted without the possibility of an erroneous transfer of data because of human error. This type of system is known as a non-contact optically isolated interface system.

Utility meters are fitted with energy consumption indicators, that may be used when calibrating and checking the accuracy of the meter. Such indicators are typically fitted so that they are visible from the front of the meter. The indicator is typically a mark on a rotating disc or a light source such as a light emitting diode (LED) that flashes.

The speed of rotation of the disc or rate of flashing of the LED is typically proportional to the rate of energy consumption.

The reasons for using an optically isolated interface are that it ensures electrical isolation between the meter and the communication equipment, and also, the communication to the meter may be made when the meter has been fully assembled where the internal circuit is otherwise protected from external effects. The non-contact optically isolated interface to the meter traditionally uses two optical devices, in the meter, for communication. One device is used to transmit information and the other device is used to receive information. Using two devices has clear cost penalties from both the cost of the part and the cost of fitting the parts, and it would therefor be of benefit if the number of parts could be reduced. By reducing the number of parts, the reliability is also increased. There are existing methods of bi-directional communication between a meter and some external equipment. The most commonly used method is that specified in IEC 1107, where two optical devices are used, one of these is used to transmit information and the other is used to receive information. A second method, which is used, is to make direct electrical connection between the circuitry of the meter and the external equipment. The disadvantage of this is that while direct electrical contact to the circuitry can be made before any external enclosure has been fitted, it is not possible to allow the same connection to be made after an enclosure has been fitted to the meter unless a sealable method of isolation be provided in the enclosure. The requirements for a sealable cover in the enclosure are required from the point of safety and anti-fraud.

The manufacture of electronic utility meters often requires that parameter values specific to the operation of that individual meter are assigned and stored in circuitry within the meter. These values could be related to the measurement accuracy calibration or the 'tariff structure, which the meter conforms to when operating, but are not restricted thereto. This information is conveniently stored on a circuit board in some form of nonvolatile memory device, which a microprocessor may read from and write to. When the information is read from the memory it is able to make use of the values to ensure that the individual meter operates as required. Before the microprocessor is able to operate the meter, the information must first be placed into the memory. To place the information into the memory, it is possible using existing techniques to write directly into a semiconductor device using electrical contact between the PCB and some external equipment, but this can be undesirable from a safety point of view. Also it is possible to use the microprocessor to write the information to the memory device by communicating the information to the microprocessor which will then perform the write operation.

As discussed above, it is common practice in the utility metering industry to provide a visible indication representing the consumption of energy which is being measured. It is also known to combine the feature of the meter reading non-contact optically isolated communication port with an LED indicator.

EP-A-242 090 (Smith Meters Ltd) provides an LCD display and a flashing light to enable meter reading using a photo-electric sensor. WO 85/05530 (NCR) provides a bi-directional optical data communications system comprising two sets of transmitters and receivers. GB-A-2 228 641 (Megger Instruments Ltd) provides a meter having a visual display and an LED output for a bar code reader.

### Object of the Invention

The present invention seeks to provide an improved metering apparatus. It is also an aim of the present invention to provide an energy consumption indicator for a metering apparatus at reduced cost.

A further aim of the present invention is to provide a relatively low cost bi-directional optical communication circuit for a utility meter.

### Statement of Invention

In accordance with a first aspect of the invention, there is provided a utility meter per claim 1.

The signal could comprise an on-off signal with an on period indicative of an amount of utility consumed.

The signal could comprise an on-off signal with a repetition frequency indicative of the rate of consumption of the utility.

The signal indicative of rate of utility consumption may be calibrated. An error in the accuracy of the meter could be determined by the meter reader.

The signals received from the meter reader could change its mode of operation to enable a tariff data change, e.g. to provide for the signalling of off-peak consumption data. Other functions could also be provided as would be known to a skilled man.

The meter can provide its dual light emission/detection properties by means of a circuit such that the LED is forward biased in a light transmit mode and is reverse biased in a light receive mode.

Conventionally, the communication LED and detector operate in the invisible portion of the optical spectrum. To provide an indication visible to the human eye, an LCD display segment associated with the meter may be provided to "flash"; this will enable a 'comfort factor' relating to a rate of utility consumption to be visible whilst enabling the LED and detector devices to operate in, for example the infra-red portion of the spectrum.

This may enable greater efficiency in the operation of a bi-directional communication circuit.

In accordance with another aspect of the invention, there is provided a utility system incorporating such meters.

The utility may be electricity, when the consumption of electrical energy would be measured in units, say KWh: in the case of water or gas the consumption would be measured in volumetric units, say m³ over time; in the case of waste fluids, the consumption would relate to a volume of effluent. In accordance with a further aspect of the invention, there is provided a method of operating a utility meter in conjunction with a meter reading device wherein; in a first mode a LED device operates to provide a visible indication of utility consumption rate; in a second mode the LED device receives an interrogation signal from a meter reader device; and in a third mode the LED device transmits signals indicative of the amount of utility consumed.

The invention provides, in another aspect, a utility meter operable to provide a visible indication of utility consumption rate, an indication of an amount of utility consumed and to detect interrogation signals from a meter reading device.

In contrast to known meters and in accordance with the invention, a single LED device is operable to provide a utility consumption rate signal, a signal indicative of an amount of utility consumed and to receive an interrogation signal from a meter reader device.

### Brief description of the figures

The invention may be understood more readily, and various other aspects and features of the invention may become apparent from consideration of the following description and the figures as shown in the accompanying drawing sheets, wherein:
Figure 1 shows a typical example of a prior art utility meter;
Figure 2 and 3 shows a schematic view of the functions of a bidirectional optical communication system;
Figure 4 shows a first example of a meter made in accordance with the invention; and
Figure 5 shows a circuit operable to enable a bi-directional signal functionality.

### Detailed description of the invention

There will now be described, by way of example, the best mode contemplated by the inventors for carrying out the invention. In the following description, numerous specific details are set out in order to provide a complete understanding of the present invention. It will be apparent, however, to those skilled in the art, that the present invention may be put into practice with variations of this specific and as determined by the appended claims.

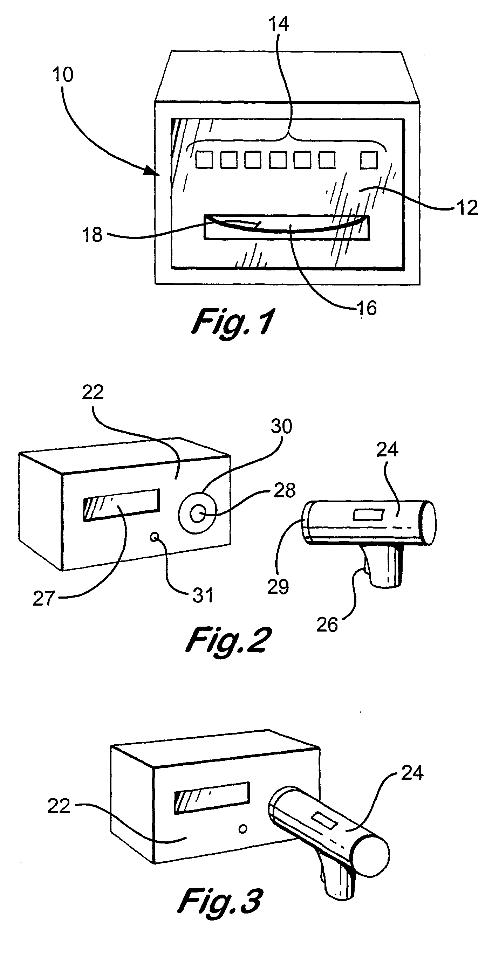

Referring now to Figure 1, there is shown a prior art mechanical utility meter, 10. Behind a glazed cover 12, the front face of the device shows a mechanical rotating digit display 14. A rotating disc 16 has a mark 18 placed on a circumferential edge. This mark is visible during a period during the revolution of the disc. The indication of utility consumption can be provided in other ways and, in the case of electrical meters is typically provided by means of a flashing LED light operating in the visible region of the optical spectrum.

Figures 2 and 3 show an overview of the process involved in meter reading using a meter 22 having a bi-directional optical communications port 28. The meter is also provided with a LCD visible display 27. The port 28 is provided with a ring 30 which aids positive location of a correspondingly shaped portion 29 of meter reading device 24. The ring 30 is conveniently magnetic. In use, and as best shown in Figure 3, the portion 29 of the meter reading device 24 is placed against ring 30. A trigger 26 may be depressed to start a measurement, when an interrogation signal would be transmitted from a light source within the meter reader device. In known systems this signal would be received by a detector within the meter; the meter would transmit consumption data by means of a separate transmitter device (not shown). Reference numeral 31 indicates an LED light source operable to indicate that consumption of utility is occurring.

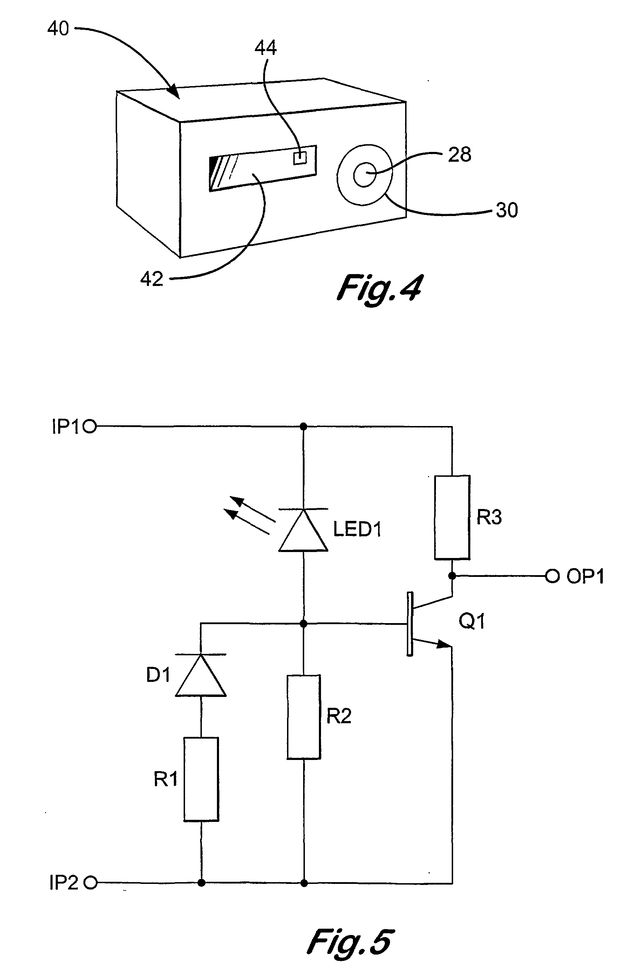

Figure 4 shows a utility meter 40, corresponding substantially with meter 20, having opto-port 28 with locator ring 30. Display 42 differs in that is can be a LCD display which shows an optional LCD indicator which is operable to enable a simple indication that utility is being consumed - the decay time for a visible display would typically prevent any meaningful determination of rate of consumption. Other types of display could also be used such a LED and VFD (Vacuum Fluorescent Display).

An embodiment of the present invention will now be described with reference to Figure 5; the invention makes use of a single LED (Light Emitting Diode). The LED could be manufactured so that it is operated in a visible or invisible (infra-red) part of the spectrum. Properties of an LED are that the diode will emit light when biased in a forward direction; this is the commonly used method of operation of an LED as a transmitter.

When an LED is reverse biased, its properties block the flow of current through the device, however, when the semiconducting device is illuminated with light of a wavelength appropriate to the type of device, then it will conduct to allow a current flow which is proportional to the amount of light by which it is illuminated. By making use of the current flowing through the device when it is illuminated by an external source, the device can be made to operate as a receiver. By arranging suitable circuitry in accordance with the present invention, the LED may be biased in either its forward direction or reverse direction as required during the communication.

In figure 5, a single light emitting diode, LED 1 is shown, with a transistor Q1 and resistors R1, R2, R3, and diode D1. The circuit is connected to the communicating device, which would traditionally be a microprocessor, through clearly it could be an ASIC or some form of discrete logic. The two electrical inputs to the circuit, IP1, IP2 are connected to the part of the communicating device which deals with the transmission of information. The output OP1 is connected to the part of the communicating device which deals with the reception of information.

The input IP1 is connected to the cathode of the light emitting diode LED1 and to one end of the resistor R3. The opposite end of R3 is connected to the collector of transistor Q1 and the output OP1. The anode of the light emitting diode LED1 is connected to the cathode of the diode D1, the base of the transistor Q1 and to one end of the resistor R2. The anode of the diode D1 is connected to one end of the resistor R1. The other end of the resistor R1, and the other end of the resistor R2 and the emitter of the transistor Q1 are connected to the input IP2.

If the inputs IP1 and IP2 are connected to a microprocessor, the microprocessor can control the settings of the logic levels and hence the voltage levels on the inputs IP1 and IP2 respectively, and the light emitting diode LED1 can be configured to be either forward or reversed biased

With the input IP1 set to logic low (0V) and the input IP2 set to logic high (+V), light emitting diode LED1 will be forward biased and the majority of current will flow through resistor R1 and diode D1. The value of resistor R1 is chosen to ensure that sufficient illumination is generated from the light emitting diode LED1 during transmission of data.

With the input IP1 set to logic high (+V) and the input IP2 set to logic low (0V), the light emitting diode LED1 will be reverse biased. When the light emitting diode LED1 is illuminated by transmitted data from the communicating equipment, a current will flow through the light emitting diode LED1 into the resistor R2, and current is blocked from going through resistor R1 by the reverse biased diode D1. If the current flowing through the light emitting diode LED1 is great enough, then the potential formed across resistor R2 will be large enough to forward bias the base emitter junction of the transistor Q1 and the transistor will switch on, causing current to flow through resistor R3, and the voltage in the output OP1 to go towards that of the input IP2.

If the circuit as described above is used in a dual opto-device method, its sensitivity may be increased by increasing the transmitted optical light level from the communicating equipment.
In a normal mode of operation, the LED will flash at a rate indicative of a rate of consumption. When a meter reading device is positioned against the opto-port 29 and the meter reading device is operated, then an interrogation pulse of light is received by the LED, acting as a detector when not in transmit mode. Typically the flash from the LED will have a duration of 2-3 ms and the period in which the LED operates as a detector would be 100ms or more: sufficient to enable an interrogation to be received. Upon receipt of such an interrogation signal, the meter will transmit data relating to the amount of utility consumed. This data may also be supplemented by meter identification data; tarriff data etc. Whilst meter reading devices do not, as a rule, operate to calibrate the meters since this is typically performed upon assembly at a site of manufactured or upon installation at a premises, this functionality could also be provided for. During the transmission of consumption data from the meter to the meter reading device, which data transfer may be repeated, the normal transmission of energy consumption rate (pulse/flash) is not performed.
As the invention makes use of a single device for both transmitted and received information, then communication between the meter and the equipment is only possible in half-duplex (i.e. one way at a time). The requirements of existing systems using two optical devices for data transfer only allow half-duplex operation and accordingly, the present invention is suitable for such applications.
A meter incorporating the features of an energy consumption indication and an optically isolated communication port, as known, would comprise a total of three optical devices, consisting of two transmitting devices and an optical receiver device.
The present invention provides a great reduction in the manufacturing and associated costs of meters - which are manufactured in their millions and where each cost reduction can have a significant. Moreover, by the reduction in number of components an increase in reliability can be expected.

## Claims

1. A utility meter (22) having a display (27), a microprocessor and an optical communications port (28);
wherein the meter is operable:
to provide an optical indication of utility consumption rate;
to detect interrogation signals from a meter reading device; and
to provide an indication of an amount of utility consumed;
**characterised in that** a single LED (LED1) is maintained in rest condition in reverse bias and is operable, periodically, in forward bias, to emit light indicative of utility consumption rate through the optical communications port;
wherein, in reverse bias conditions, upon illumination through the optical communications port, the LED is operable to allow current flow responsive to optical interrogation signals, whereupon the microprocessor is operable to cause the LED to provide a signal indicative of an amount of utility consumed.

2. A meter in accordance with claim 1 wherein the signal indicative of rate of utility consumption comprises an on-off signal with an on period indicative of a rate of utility consumed.

3. A meter in accordance with claim 1 wherein the signal indicative of rate of utility consumption comprises an on-off signal with a repetition frequency indicative of an amount of utility consumed.

4. A meter in accordance with any one of claims 1 to 3 wherein the meter reading device is operable to determine errors in calibration of the meter.

5. A meter in accordance with claim 1 wherein the signal indicative of an amount of utility consumption comprises an on-off signal with a repetition frequency indicative of the amount of utility consumed.

6. A meter in accordance with any one of claims 1 to 5 wherein the meter reading device is operable to determine errors in calibration of the meter.

7. A meter in accordance with any one of claims 1 to 6 wherein the signals received from the meter reader device are operable to determine a calibration of the meter or to change its mode of operation.

8. A meter in accordance with any one of claims 1 to 7 wherein the LED device transmits in a visible portion of the optical spectrum.

9. A meter in accordance with any one of claims 1 to 8 wherein there is provided a visual display of the meter reading on a face of the meter, which display further provides an indication that a utility is being consumed.

10. A utility metering system comprising one or more utility meters as claimed in any claims 1 to 9.

11. A method of operating a utility meter (22) in conjunction with a meter-reading device (24) wherein;
in a first mode a LED (LED1) device is forward biased and operates to provide a visible indication of utility consumption rate;
in a second mode the LED device is reverse biased and receives an interrogation signal from a meter reader device; and
in a third mode the LED device is forward biased and transmits signals indicative of the amount of utility consumed.

## Patentansprüche

1. Ein Energiemessgerät (22), das ein Display (27) einen Mikroprozessor und eine optische Kommunikationsstelle (28) aufweist;
wobei das Messgerät Folgendes durchführen kann:
- optisch die Energieverbrauchsrate darstellen;
- Abfragesignale von einem Messwertablesegerät erkennen; und
- eine Anzeige für den Wert der verbrauchten Energie vorsehen;
**dadurch gekennzeichnet, dass** eine einzige LED (LED1) im Ruhezustand rückwärts gepolt wird und periodisch, vorwärts gepolt, eine Lichtanzeige einer Energieverbrauchsrate über die Kommunikationsstelle erzeugt;
wobei unter der Bedingung einer rückwärts gerichteten Polung per Beleuchtung über die Kommunikationsstelle die LED tätig wird und Strom durchlässt, der ansprechempfindlich für optische Abfragesignale wird, worauf der Mikroprozessor anspricht und verursacht, dass die LED eine Signalanzeige des Energieverbrauchswertes abgibt.

2. Ein Gerät gemäß Anspruch 1, wobei die Signalanzeige der Energieverbrauchsrate ein Zweipunktsignal mit einer Einschaltszeit-Anzeige einer Energieverbrauchsrate enthält.

3. Ein Messgerät gemäß Anspruch 1, wobei die Signalanzeige der Energieverbrauchsrate ein Zweipunktsignal mit einer Wiederholungsfrequenzanzeige der Energieverbrauchsrate enthält.

4. Ein Messgerät gemäß einem der Ansprüche 1 bis 3, wobei das Messwertablesegerät tätig wird, um Fehler bei der Eichung festzustellen.

5. Ein Messgerät gemäß Anspruch 1, wobei die Signalanzeige der Energieverbrauchsrate ein Zweipunktsignal mit einer Wiederholungsfrequenz-Anzeige des verbrauchten Energiewerts enthält.

6. Ein Messgerät gemäß einem der Ansprüche 1 bis 5, wobei das Messwertablesegerät tätig wird, um Fehler bei der Eichung des Messgeräts festzustellen.

7. Ein Messgerät gemäß einem der Ansprüche 1 bis 6, wobei die Signale, die vom Messwertablesegerät empfangen werden, benutzt werden, um die Eichung des Messgeräts zu bestimmen oder um seinen Betriebsmodus zu verändern.

8. Ein Messgerät gemäß einem der Ansprüche 1 bis 7, wobei die LED-Vorrichtung im sichtbaren Teil des optischen Spektrums sendet.

9. Ein Messgerät gemäß einem der Ansprüche 1 bis 8, wobei ein visuelles Display des Messgeräts zum Ablesen an der Stirnfläche des Messgeräts vorgesehen ist, wobei das Display ferner anzeigt, dass Energie verbraucht wird.

10. Ein Energiemesssystem, das ein oder mehrere Energiemessgeräte enthält, die in einem der Ansprüche 1 bis 9 beansprucht werden.

11. Eine Arbeitsweise eines EnergieMessgeräts (22) in Verbindung mit einem Messwertablesegerät (24), wobei:
- in einem ersten Modus eine LED (LED1) -Vorrichtung vorwärts gepolt ist und eine sichtbare Anzeige der Energieverbrauchsrate erzeugt;
- in einem zweiten Modus eine LED (LED1) -Vorrichtung rückwärts gepolt ist und ein Abfragesignal von einem Messwertablesegerät empfängt; und
- in einem dritten Modus eine LED (LED1) -Vorrichtung vorwärts gepolt ist und Signale übermittelt, die den Wert der verbrauchten Energie anzeigen.

## Revendications

1. Un compteur d'énergie (22) ayant un affichage (27), un micro-processeur et un port de communication optique (28),
le compteur fonctionnant afin
de fournir une indication optique du débit de consommation d'énergie,
de détecter les signaux d'interrogation venant d'un dispositif de lecture de compteurs et
de fournir l'indication de la quantité d'énergie consommée,
**caractérisé par** une seule DEL (DEL1) maintenue en repos quand polarisée en sens inverse et fonctionnant périodiquement quand polarisée en sens direct pour émettre une indication lumineuse de débit de consommation d'énergie passant par le port de communication optique,
alors que, quand polarisée en sens inverse, sur illumination par le port de communication optique, la DEL fonctionne permettant au courant de passer, réagissant aux signaux optiques d'interrogation, sur quoi le micro-processeur est en mesure de fonctionner pour permettre à la DEL de fournir un signal indiquant la quantité d'énergie consommée.

2. Un compteur conformément à la revendication 1 où le signal indiquant le débit de consommation d'énergie comprend un signal marche-arrêt avec une période marche indiquant le débit de l'énergie consommée.

3. Un compteur conformément à la revendication 1 où le signal indiquant le débit de l'énergie consommée comprend un signal marche-arrêt avec une fréquence de répétition indiquant une quantité d'énergie consommée.

4. Un compteur conformément à l'une quelconque des revendications 1 à 3 où le dispositif de lecture de compteur fonctionne en vue de déterminer les erreurs d'étalonnage du compteur.

5. Un compteur conformément à la revendication 1 où le signal indiquant la quantité d'énergie consommée comprend un signal marche-arrêt avec une fréquence de répétition indiquant une quantité d'énergie consommée.

6. Un compteur conformément à l'une quelconque des revendications 1 à 5 où le dispositif de lecture du compteur fonctionne pour déterminer les erreurs d'étalonnage du compteur.

7. Un compteur conformément à l'une quelconque des revendications 1 à 6 où les signaux reçus depuis le dispositif de lecture du compteur fonctionnent pour déterminer un étalonnage du compteur ou changer son mode opératoire.

8. Un compteur conformément à l'une quelconque des revendications 1 à 7 où le dispositif de la DEL transmet dans un segment visible du spectre optique.

9. Un compteur conformément à l'une quelconque des revendications 1 à 8 où il est pourvu à un affichage visuel de lecture du compteur sur une face du compteur, lequel affichage indique qu'une énergie est consommée actuellement.

10. Un système de mesure de consommation d'énergie comprenant un ou plusieurs compteurs de consommation d'énergie comme revendiqué dans l'une quelconque des revendications 1 à 9.

11. Une méthode de fonctionnement d'un compteur de consommation d'énergie(22) conjuguée à un dispositif de lecture de compteurs (24) où,
dans un premier mode, un dispositif DEL (DEL1) est polarisé en sens direct et fonctionne en vue de fournir une indication visible du débit de consommation d'énergie ;
dans un deuxième mode, le dispositif DEL est polarisé en sens inverse et reçoit un signal d'interrogation du dispositif de lecteur de compteurs; et
dans un troisième mode, le dispositif DEL est polarisé en sens direct et transmet des signaux indiquant la quantité d'énergie consommée.
